# EUROPEAN PATENT APPLICATION

(11) **EP 4 852 700 A1**
(43) Date of publication of application: **09.12.2026**
(21) Application number: 25211471.5
(22) Date of filing: 27.10.2025
(51) Int. Cl.: H10W 40/25, H10W 74/15, H10W 90/20

(54) **MULTILAYER NANOFILM AND STACKED SEMICONDUCTOR DEVICE INCLUDING THE SAME**

(30) Priority: 04.06.2025 KR 20250073224
(71) Applicant: UNIVERSITY OF ULSAN FOUNDATION FOR INDUSTRY COOPERATION, Nam-gu Ulsan 44610 (KR)
(72) Inventor: KIM, Bo Hung, 44610 Ulsan (KR); SIDDIQUE, M. Zeeshan, 44610 Ulsan (KR); PYEON, Janghyeon, 44610 Ulsan (KR)
(74) Representative: Zacco Sweden AB

(57) **Abstract**

The multilayer nanofilm includes a plurality of base layers arranged to be spaced apart along a stacking direction, and a plurality of alternating layers having a composition different from that of the plurality of base layers and interposed between the plurality of base layers such that each of the plurality of alternating layers is alternately disposed with respect to each of the plurality of base layers along the stacking direction and in contact with at least one of the base layers that are adjacent to each other along the stacking direction. Each of the plurality of base layers and the plurality of alternating layers has an angstrom-scale or a nanoscale unit thickness to provide a nanoscale stack thickness, so that thermal insulation along the stacking direction and heat dissipation along the horizontal direction can be performed.

## Description

### BACKGROUND

### 1. Field

This research was supported by the National Research Foundation of Korea (NRF) grant funded by the Korean government (Ministry of Science and ICT) (RS-2023-00272214).

The present disclosure relates to multilayer nanofilms and stacked semiconductor devices including the same, and more specifically, to multilayer nanofilms in which thin films of different materials are stacked with nanoscale thicknesses, and stacked semiconductor devices including the same.

### 2. Description of the Related Art

As the demand for semiconductor devices capable of processing large-scale data, such as those used in artificial intelligence and data centers, continues to grow, the demand for highly integrated semiconductor devices has also been increasing.

Recently, with the development of fine processing technologies that reduce line width to the nanoscale, the physical size of semiconductor chips has approached its miniaturization limit. Accordingly, interest has been increasing in stacked semiconductor devices that enhance integration density and expand bandwidth by stacking multiple semiconductor chips.

A stacked semiconductor device is implemented as a single device by packaging a plurality of heterogeneous or homogeneous semiconductor chips, and research has been conducted on various technical issues such as signal transmission between individual chips, molding for integrating the chips into a single device, and heat dissipation between the chips.

In this case, when heterogeneous semiconductor chips are bonded to implement a stacked semiconductor device, differences in operating heat generated by each chip may cause thermal burden on one of the chips or warpage of the dies, frequently leading to malfunction of the stacked semiconductor device.

In particular, in the case where a memory chip and a logic chip are bonded to implement a single stacked semiconductor device, the excessive operating heat generated by the logic chip compared to the memory chip tends to accumulate in the memory chip, causing malfunctions in the memory chip and frequently reducing the operational stability of the stacked semiconductor device.

To prevent this, a heat insulating layer for thermal insulation in the vertical direction and a heat dissipating layer for heat dissipation in the horizontal direction may be arranged together between memory chip and logic chip. That is, the stacked semiconductor device may be configured such that the operating heat generated by the logic chip is blocked by the heat insulating layer from being transferred to the memory chip along the stacking direction and is conducted in a direction perpendicular to the stacking direction by the heat dissipating layer and dissipated to the outside.

However, the arrangement of the heat insulating layer and the heat dissipating layer separately between the logic chip and the memory chip may be a major factor in increasing the thickness of the stacked semiconductor device. This runs directly counter to the trend of integration in semiconductor devices, where fine processing technologies are being applied.

### SUMMARY

The present invention is proposed to solve the aforementioned problems, and an object of the present disclosure is to provide a multilayer nanofilm in which heterogeneous thin films with different compositions are stacked at the nanoscale, enabling both thermal insulation in the stacking direction and heat dissipation in the direction perpendicular thereto.

Another object of the present disclosure is to provide a stacked semiconductor device including the multilayer nanofilm as described above.

The technical problems of the present invention are not limited to the aforementioned objects, and other objects and advantages of the present invention that are not explicitly mentioned are evidently understood from the following description and will become more apparent from the embodiments of the present invention. It will also be readily understood that the objects and advantages of the present invention are capable of being realized by the means and their combinations set forth in the claims of the invention.

The present invention may provide a multilayer nanofilm with a nanoscale thickness, which is capable of simultaneously performing thermal insulation in the thickness direction and heat dissipation along a plane perpendicular to the thickness direction.

The present invention may provide a stacked semiconductor device having excellent thermal insulation performance in the stacking direction in which heterogeneous chips or homogeneous chips are stacked and heat dissipation performance along a plane perpendicular to the stacking direction.

According to an aspect of the inventive concept, there is provided a multilayer nanofilm including a plurality of base layers arranged to be spaced apart along a stacking direction, and a plurality of alternating layers having a composition different from that of the plurality of base layers and interposed between the plurality of base layers such that each of the plurality of alternating layers is alternately disposed with respect to each of the plurality of base layers along the stacking direction and in contact with at least one of the base layers that are adjacent to each other along the stacking direction, wherein each of the plurality of base layers and the plurality of alternating layers has an angstrom-scale or a nanoscale unit thickness to provide a nanoscale stack thickness, thereby being configured to simultaneously perform thermal insulation along the stacking direction and heat dissipation along a horizontal direction perpendicular to the stacking direction.

In an embodiment, each of the plurality of base layers and the plurality of alternating layers may be configured as one of a single layer and a multilayer.

In an embodiment, the single layer may include one of a two-dimensional material having an angstrom-scale thickness and a nanofilm having a nanoscale thickness, and the multilayer may include a stack structure in which at least one of the two-dimensional material, the nanofilm, and a combination thereof is stacked.

In an embodiment, each of the plurality of base layers may be composed of the two-dimensional material having a first composition, and each of the plurality of alternating layers may be composed of the two-dimensional material having a second composition, so that a single atomic layer of the first composition and a single atomic layer of the second composition are alternately bonded along the stacking direction.

In an embodiment, each of the plurality of base layers may be composed of the two-dimensional material having a first composition, and each of the plurality of alternating layers may be configured as a plurality of nanofilms having a second composition, so that a single atomic layer of the first composition and a multilayer of the second composition are alternately bonded in the stacking direction.

In an embodiment, each of the plurality of base layers and the plurality of alternating layers may include one of graphene, silica (SiO₂), transition metal dichalcogenide (TMD), layered double hydroxide (LDH), covalent organic framework (COF), metal organic framework (MOF), two-dimensional metals, two-dimensional transition metal oxides, two-dimensional black materials, hexagonal boron nitride (h-BN), and a compound thereof.

In an embodiment, the plurality of base layers include graphene, and the plurality of alternating layers include one of the two-dimensional metal, silica (SiO₂), and a compound thereof.

In an embodiment, the 2-dimensional metal includes one of copper, gold, silver, and a compound thereof.

In an embodiment, heat conducted along a horizontal direction perpendicular to the stacking direction within each of the plurality of base layers and the plurality of alternating layers may be configured to dissipate toward through side surfaces thereof, and heat conducted along the stacking direction may be configured to be blocked by interfacial thermal resistance provided at the interfaces between the base layer and the alternating layer adjacent to each other.

In an embodiment, lattice structures of the base layer and the alternating layer at the interface may have a size smaller than a mean free path of phonons, and the interfacial thermal resistance may include a Kapitza resistance.

In an embodiment, the plurality of base layers includes two to three graphene layers, and the plurality of alternating layers includes three to four copper layers.

In an embodiment, the stack thickness is in a range of 1/6 to 1/5 of a bulk film thickness having the same thermal resistance as the interfacial thermal resistance.

In an embodiment, the plurality of base layers may be configured as two graphene layers and the plurality of alternating layers may be configured as three copper layers, thereby implementing the multilayer nanofilm having a stack thickness of approximately 6nm.

According to another embodiment of the present invention, there is provided a stacked semiconductor device including a base die including a first integrated circuit, a stack die including a second integrated circuit and disposed on the base die along a stacking direction perpendicular to the base die such that the second integrated circuit is bonded to the first integrated circuit, and a multilayer nanofilm positioned between the base die and the stack die, the multilayer nanofilm including a plurality of base layers and a plurality of alternating layers that are alternately stacked and in contact with adjacent base and alternating layers along the stacking direction, each of the plurality of base layers and the plurality of alternating layers having an angstrom-scale or a nanoscale unit thickness, such that the multilayer nanofilm has a nanoscale stack thickness and is configured to simultaneously perform thermal insulation along the stacking direction and heat dissipation along a horizontal direction perpendicular to the stacking direction.

In an embodiment, each of the plurality of base layers and the plurality of alternating layers may be configured as one of a single layer including one of a two-dimensional material having an angstrom-scale thickness and a nanofilm having a nanoscale thickness, and a multilayer including a stack structure in which at least one of the two-dimensional material, the nanofilm, and a combination thereof may be stacked.

In an embodiment, each of the plurality of base layers may be composed of the two-dimensional material having a first composition, and each of the plurality of alternating layers may be composed of the two-dimensional material having a second composition, so that a single atomic layer of the first composition and a single atomic layer of the second composition are alternately bonded along the stacking direction.

In an embodiment, each of the plurality of base layers may be composed of the two-dimensional material having a first composition, and each of the plurality of alternating layers may be configured as a plurality of nanofilms having a second composition, so that a single atomic layer of the first composition and a multilayer of the second composition are alternately bonded in the stacking direction.

In an embodiment, the plurality of base layers may include graphene, and the plurality of alternating layers may include one of the two-dimensional metal, silica (SiO₂), and a compound thereof.

In an embodiment, the 2-dimensional metal may include one of copper, gold, silver, and a compound thereof.

In an embodiment, the plurality of base layers may include two to three graphene layers and the plurality of alternating layers may include three to four copper layers, and the stack thickness is in a range of 3 nm to 10 nm.

In an embodiment, the base die may further include a plurality of upper base pads arranged on an upper base surface, which is an upper surface of the base die, and electrically connected to the first integrated circuit, a plurality of lower base pads arranged on a lower base surface, which is a lower surface of the base die, corresponding respectively to the upper base pads, and a plurality of base penetrating electrode penetrating through the base die such that the corresponding upper base pads and lower base pads are connected to each other.

In an embodiment, the stack die may include a plurality of upper stack pads arranged on an upper stack surface, which is an upper surface of the stack die, and electrically connected to the second integrated circuit, a plurality of lower stack pads arranged on a lower stack surface, which is a lower surface of the stack die, corresponding respectively to the upper stack pads, and a plurality of stack penetrating electrode penetrating through the stack die such that the corresponding upper stack pads and lower stack pads are connected to each other.

In an embodiment, each of the base penetrating electrode and the stack penetrating electrode may include a through-silicon via (TSV).

In an embodiment, each of the upper base pad, the lower base pad, the upper stack pad, and the lower stack pad may include one of a bonding bump and a solder ball.

In an embodiment, the stacked semiconductor device may further include a plurality of bonding portions configured to bond the lower stack pad and the corresponding upper base pad to electrically connect the lower stack pad and the upper base pad, the plurality of bonding portions being enclosed by the multilayer nanofilm, a fixing mold configured to secure the stack die to the base die with the multilayer nanofilm interposed therebetween and expose a surface of the stack die, and a heat sink configured to remove operating heat generated by the base die and the stack die to the outside.

In an embodiment, the plurality of bonding portions may include a ball grid array (BGA) in which a plurality of base solder balls are arranged in a matrix pattern within the multilayer nanofilm, such that each side surface of the plurality of base solder balls is in contact with the multilayer nanofilm in the horizontal direction.

In an embodiment, the multilayer nanofilm may be in contact with the upper base surface, the lower stack surface, and a lower surface of the fixing mold, and may be provided as a heat dissipating layer that dissipates heat radiated from the lower stack pad, the upper base pad, and the plurality of bonding portions in the horizontal direction, and as a heat insulating layer that blocks the operating heat generated by the base die and the stack die in the stacking direction to thermally insulate the base die and the stack die.

In an embodiment, the multilayer nanofilm may be provided as an electrical insulating layer that blocks charge oscillations in the stacking direction, thereby electrically insulating the base die from the stack die.

In an embodiment, the fixing mold may be arranged to surround the stack die and cover the multilayer nanofilm.

In an embodiment, a plurality of stack dies may be arranged on the base die, and between the adjacent stack dies, a plurality of additional upper stack pads and additional lower stack pads and a plurality of bonding pads may be provided, such that the corresponding additional upper and lower stack pads are electrically connected via the corresponding bonding pad.

In an embodiment, an upper surface of the fixing mold may be positioned at the same level as the upper stack surface of an uppermost stack die and the uppermost stack die may be surrounded by the fixing mold, so that the upper stack surface of the uppermost stack die is exposed from the fixing mold.

In an embodiment, the heat sink may include a first sink in contact with the lower base surface and configured to remove a first operating heat generated by the base die, a second sink in contact with the upper stack surface and an upper surface of the fixing mold and configured to remove a second operating heat generated from the stack die to the outside, a third sink in contact with a side surface of the multilayer nanofilm and configured to remove a third operating heat generated during signal transmission through the plurality of bonding portions and transferred laterally in the horizontal direction, to the outside.

In an embodiment, the first sink may include a first thermal interface material layer configured to cover the lower base surface and absorb the first operating heat, and a first heat removal plate configured to cover the first thermal interface material layer and remove the first operating heat to the outside.

In an embodiment, the stacked semiconductor device may further include an external connecting via configured to pass through the first sink and bond to the lower base pad, and an external connecting pad bonded to the external connecting via on the surface of the first heat removal plate and configured to be electrically connected to an external device.

In an embodiment, the second sink may include a second thermal interface material layer configured to cover the upper stack surface and an upper surface of the fixing mold and absorb the second operating heat, and a second heat removal plate configured to cover the second thermal interface material layer and remove the second operating heat to the outside.

In an embodiment, the third sink may include a heat removal ring that extends in a ring shape along an outer side and is in contact with a side surface of the multilayer nanofilm.

In an embodiment, the third sink may include at least one heat removal column configured to penetrate through the fixing mold and the multilayer nanofilm, such that end surfaces thereof are in contact with the base die and the second sink, respectively.

In an embodiment, the third sink may include a removal wall configured to cover side surfaces of the fixing mold, the multilayer nanofilm, and the base die, such that end surfaces thereof are in contact with the first sink and the second sink, respectively.

In an embodiment, the base die may include at least one of a logic chip and an application-specific integrated circuit (ASIC) chip, and the stack die includes a memory chip.

In an embodiment, the base die may include at least one of a central processing unit (CPU) for driving a computer system, a graphic processing unit (GPU) for processing graphic data, and an application processor (AP) for driving a mobile device.

In an embodiment, the base die may include a buffer chip and the stack die includes a plurality of dynamic random access memory (DRAM) chips, thereby implementing a high-bandwidth memory (HBM) device.

In an embodiment, the base die may include at least one of an image signal processing device and a digital signal processing device, and the stack die includes a system-on-chip (SoC) device in which memory chips are stacked.

According to example embodiments of the present invention, a multilayer nanofilm having a nanoscale stack thickness includes a plurality of base layers and a plurality of alternating layers, a Kapitza resistance occurs at an interface between the adjacent base and alternating layers.

The base layer and the alternating layer are composed of heterogeneous materials having an angstrom-scale or nanoscale unit thickness. The lattice sizes of the base layer and the alternating layer are smaller than the mean free path of phonons, thereby exhibiting thermal resistance caused by the angstrom-scale or nanoscale thickness.

Accordingly, the multilayer nanofilm can exhibit thermal insulation properties along the stacking direction.

The base layer and the alternating layer are composed of a thermally conductive metal material or a two-dimensional material, which allows heat to flow along the interfaces between the base layer and the alternating layer. Accordingly, the heat dissipation in the horizontal direction can be enhanced.

In addition, the multilayer nanofilm can block the charge oscillation together with the phonon vibration in the stacking direction, thereby preventing both heat transfer and electrical current flow in the stacking direction. As a result, the multilayer nanofilm enhances electrical insulation along with its thermal insulation and heat dissipation.

In conventional stacked semiconductor devices in which the base die and the stack die are stacked, the heat insulating layer, the heat dissipating layer, and the electrical insulating layer are required to remove the operating heat generated by the base die and the stack die and the signal transmission heat generated during signal transmission between the base die and the stack die.

Accordingly, by replacing the conventional heat insulating layer, heat dissipating layer, and electrical insulating layer with the single multilayer nanofilm according to the present disclosure, the overall thickness of the stacked semiconductor device may be reduced without deterioration in thermal insulation, heat dissipation, or electrical insulation performance.

In addition to the effects described above, the specific effects of the present invention will be described while explaining the detailed embodiments for carrying out the invention.

### BRIEF DESCRIPTION OF THE DRAWINGS

Embodiments will be more clearly understood from the following detailed description taken in conjunction with the accompanying drawings in which:
FIG. 1 is a perspective view illustrating a multilayer nanofilm, according to an embodiment of the present disclosure;
FIG. 2 is an exploded perspective view of the multilayer nanofilm illustrated in FIG. 1;
FIG. 3 is a conceptual view illustrating the structure of a bulk nanofilm made of a single material at the nanoscale;
FIG. 4 is a conceptual view illustrating the structure of a first heterogeneous nanofilm into which a single graphene atomic layer is inserted into the bulk nanofilm shown in FIG. 3;
FIG. 5 is a conceptual view illustrating the structure of a second heterogeneous nanofilm in which a plurality of graphene atomic layers are alternately arranged between a plurality of atomic layers of the bulk nanofilm shown in FIG. 3;
FIG. 6 is a view illustrating a Kapitza resistance and a Kapitza length generated during a heat transfer between heterogeneous solid planes;
FIG. 7 is a view illustrating the change in Kapitza length according to the number of graphene atomic layers inserted into the homogeneous film shown in FIG. 6;
FIG. 8 is a view illustrating a stacked semiconductor device including the multilayer nanofilm shown in FIG. 1, according to an embodiment of the present disclosure;
FIG. 9 is a view illustrating a stack die, according to another embodiment of the present disclosure;
FIG. 10 is a view illustrating a first modified embodiment of the stacked semiconductor device shown in FIG. 8;
FIG. 11 is a view illustrating a second modified embodiment of the stacked semiconductor device shown in FIG. 8;
FIG. 12 is a view illustrating a third modified embodiment of the stacked semiconductor device shown in FIG. 8; and
FIG. 13 is a view illustrating a fourth modified embodiment of the stacked semiconductor device shown in FIG. 8.

### DETAILED DESCRIPTION OF THE EMBODIMENTS

Hereinafter, preferred embodiments of the present invention will be described in detail with reference to the accompanying drawings.

The present invention is not limited to an embodiment disclosed below and may be modified in various ways and implemented in various different forms. The present embodiment is provided merely to make the disclosure of the present invention complete and to fully inform those skilled in the art of the scope of the invention. Accordingly, the present invention is not limited to the embodiments disclosed below, and it should be understood to include all modifications, equivalents, and alternatives within the technical spirit and scope of the invention, including substituting or adding the components of one embodiment with those of another embodiment.

The accompanying drawings are provided merely to facilitate an understanding of the embodiments disclosed in this specification, and the technical idea disclosed in this specification is not limited by the accompanying drawings. It should be understood to include all modifications, equivalents, and alternatives within the spirit and technical scope of the present invention. Although the components shown in the drawings may be exaggeratedly enlarged or reduced in size or thickness for the sake of convenience of understanding, this should not be construed as limiting the scope of protection of the present invention.

The terminology used in the present specification is employed merely to describe particular embodiments or examples and is not intended to limit the present invention. Furthermore, the singular expressions include the plural expressions unless the context clearly indicates otherwise. In the specification, terms such as 'include' or 'comprise' are intended to indicate the presence of the features, numbers, steps, operations, components, parts, or combinations thereof described in the specification. That is, in the specification, terms such as 'include' or 'comprise' should be understood as not precluding the presence or addition of one or more other features, numbers, steps, operations, components, parts, or combinations thereof.

Terms including ordinals such as 'first' and 'second' may be used to describe various components, but the components are not limited by these terms. The terms are used solely for the purpose of distinguishing one component from another. Accordingly, unless explicitly stated otherwise, the first component may also be the second component.

When a component is described as being 'connected to' or 'coupled to' another component, it should be understood that the component may be directly connected or coupled to the other component, or that one or more other components may exist therebetween. On the other hand, when a component is described as being 'directly connected' or 'directly coupled' to another component, it should be understood that no other components exist in between.

When a component is described as being 'above' or 'below' another component, it should be understood that the component may not only be disposed immediately above or below the other component, but that one or more other components may exist in between.

Unless otherwise defined, all terms used herein, including technical and scientific terms, have the same meanings as those generally understood by one of ordinary skill in the art to which the present invention belongs. Terms that are generally defined in dictionaries should be interpreted as having meanings consistent with their meanings in the context of the relevant art, and unless explicitly defined in the present application, they are not to be interpreted in an idealized or overly formal sense.

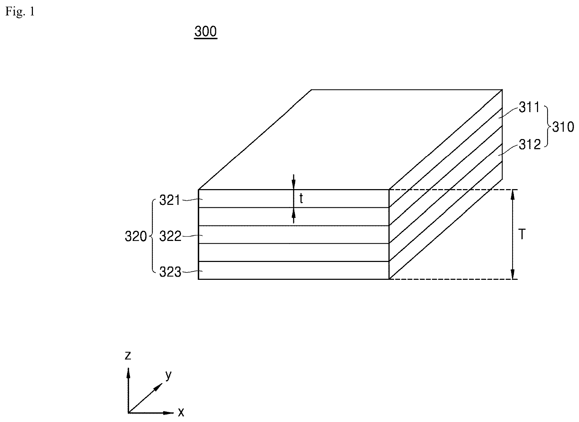

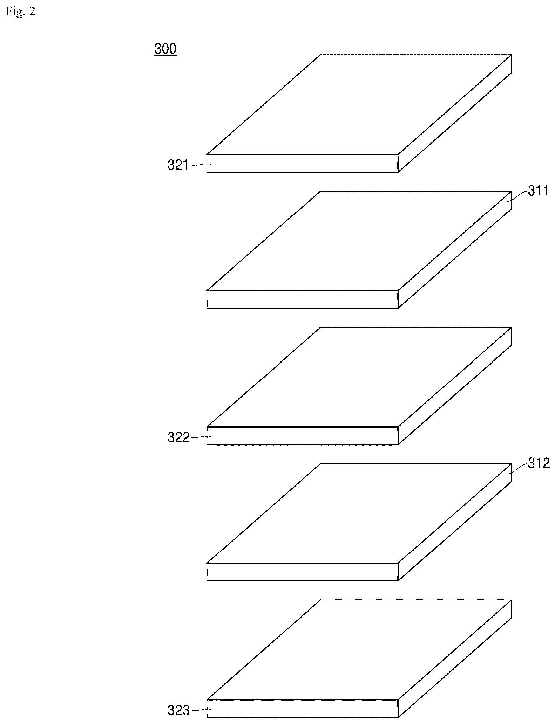

FIG. 1 is a perspective view illustrating a multilayer nanofilm according to an embodiment of the present disclosure, and FIG. 2 is an exploded perspective view of the multilayer nanofilm illustrated in FIG. 1.

Referring to FIGS. 1 and 2, the multilayer nanofilm 300 according to an embodiment of the present disclosure may include a plurality of base layers 310 spaced apart along the stacking direction z and a plurality of alternating layers 320 that are alternately disposed and in contact with the base layers 310 adjacent to each other.

The multilayer nanofilm 300 may have a multilayered structure in which a plurality of alternating layers 320 are inserted between the plurality of base layers 310 arranged to be spaced apart from each other in a stacking direction z, so that the base layer 310 and the alternating layer 320 are alternately bonded.

The plurality of base layers 310 may be spaced apart along the stacking direction z, and the plurality of alternating layers 320, having a composition different from that of base layers 310, may be interposed between the plurality of base layers 310. The alternating layers may be alternately arranged with the respective base layers 310 along the stacking direction z and may be configured to be in contact with at least one base layer 310 adjacent thereto in the stacking direction z.

In particular, each of the base layers 310 and the alternating layers 320 may have a unit thickness t on an angstrom-scale or a nanoscale, and the multilayer nanofilm 300 may have a stack thickness T at the nanoscale.

Therefore, the multilayer nanofilm 300 may serve as a thermal insulation member that suppress heat transfer by significantly reducing the heat conduction coefficient in the stacking direction z.

In addition, the base layer 310 and the alternating layer 320 may be formed of a material having high thermal conductivity and may be configured to efficiently conduct heat in a horizontal direction, that is, along a plane perpendicular to the stacking direction z. Accordingly, the heat generated within the base layer 310 and the alternating layer 320 may be dissipated outward by being conducted along the horizontal direction.

Therefore, the multilayer nanofilm 300 may simultaneously exhibit thermal insulation properties along the stacking direction z and heat dissipation properties along the horizontal direction.

For example, each of the base layer 310 and the alternating layer 320 may be configured as a single layer or a multilayer. In this case, the single layer may be configured of either a two-dimensional material having an angstrom-scale thickness or a nanofilm having a nanoscale thickness, and the multilayer may be configured as a stacked structure of the two-dimensional material, the nanofilm, or a mixed structure thereof.

The two-dimensional (2D) material may be composed of a single atomic layer or several atomic layer having an angstrom-scale thickness and form a planar crystal with significantly large in-plane dimensions, making it difficult for heat or charge to be injected in the direction perpendicular to the plane.

In addition, the nanofilm may be a thin film having a nanoscale thickness and may have a characteristic that heat transfer through the nanofilm becomes difficult due to a decrease in thermal conductivity at the nanoscale.

In particular, in the case of the two-dimensional material or the nanofilm, the crystal size at the surface may be smaller than the mean free path of phonons, which makes heat transfer through the surface difficult. Accordingly, the two-dimensional material or the nanofilm may inherently exhibit excellent thermal insulation properties by itself.

The base layer 310 and the alternating layer 320 may have different compositions. Accordingly, the multilayer nanofilm 300 may be configured as a heterogeneous multilayered film.

When the base layer 310 and the alternating layer 320, having angstrom-scale or nanoscale dimensions, are formed of different compositions, a Kapitza resistance may be generated at the interface, arising from a temperature drop due to differences in crystals characteristics.

That is, the Kapitza resistance may be generated at the interface between the base layer 310 and the alternating layer 320 formed of the heterogeneous material, thereby suppressing heat transfer to the interior and promoting a heat flow along the interface.

Accordingly, when a plurality of base layers 310 and a plurality of alternating layers 320, each composed of the two-dimensional material or nanofilm, are alternately stacked along the stacking direction z, the thermal insulation performance may be enhanced due to the intrinsic thermal resistance of the base layers 310 or alternating layers 320, as well as the Kapitza resistance at the interfaces between the heterogeneous materials forming the base layers 310 and alternating layers 320.

In addition, when the two-dimensional material or the nanofilm is formed of a material with high thermal conductivity, the heat transfer performance along the horizontal direction within the base layer 310 or the alternating layer 320 may be enhanced. In addition, the heat flow at the interface between the base layer 310 and the alternating layer 320, arising from the Kapitza resistance, may enhance the heat transfer performance along the horizontal direction.

Accordingly, the heat dissipation properties of the multilayer nanofilm 300 composed of heterogeneous materials may also be enhanced.

For example, when each of the plurality of base layers 310 may be made of a two-dimensional material with a first composition, and each of the plurality of alternating layers 320 may be formed of a two-dimensional material with a second composition, the multilayer nanofilm 300 may be implemented as a stacked structure in which single atomic layers of the first and second compositions are alternately bonded.

Alternatively, when each of the plurality of base layers 310 may be made of a two-dimensional material with the first composition, and each of the plurality of alternating layers 320 may include a plurality of nanofilm with the second composition, the multilayer nanofilm 300 may be implemented as a stacked structure in which a single atomic layer of the first composition and a multilayer of the second composition are alternately bonded.

However, this is merely illustrative, and it will be apparent to those skilled in the art that the multilayer nanofilm 300 may be implemented as a stacked structure in which the base layer 310 with the first composition formed as a multilayer and the alternating layer 320 with the second composition formed as a single layer are alternately bonded.

In this embodiment, the plurality of base layers 310 may include a first base nanolayer 311 and a second base nanolayer 312, and the plurality of alternating layers 320 may include first to third alternating nanolayers 321, 322, and 323.

The first base nanolayer 311 and the second base nanolayer 312 may be arranged to be spaced apart from each other, and the first alternating nanolayer 321 may be arranged on the first base nanolayer 311, the second alternating nanolayer 322 may be positioned between the first base nanolayer 311 and the second base nanolayer 312, and the third alternating nanolayer 323 may be arranged below the second base nanolayer 312.

Accordingly, the plurality of base layers 310 and the plurality of alternating layers 320 may be alternately arranged along the stacking direction z with respect to the base layer 310.

In addition, the first to third alternating nanolayers 321, 322, and 323 may be in contact with at least one of the first base nanolayer 311 and the second base nanolayer 312, which are adjacent to each other, so that the multilayer nanofilm 300 may be formed as a single film in which the plurality of base layers 310 and the plurality of alternating layers 320 are in contact.

In this case, the base layer 310 and the alternating layer 320 may include different compositions. That is, the first and second base nanolayers 311 and 312 and the first to third alternating nanolayers 321, 322, and 323 may be formed of different materials, thereby providing a heterogeneous surface contact between each base layer and its adjacent alternating layer.

For example, the base layer 310 and the alternating layer 320 may include any one of graphene, silica (SiO₂), transition metal dichalcogenide (TMD), layered double hydroxide (LDH), covalent organic framework (COF), metal organic framework (MOF), two-dimensional metals, two-dimensional transition metal oxides, two-dimensional black materials, hexagonal boron nitride (h-BN), and a compound thereof.

In this embodiment, the base layer 310 may include graphene and the alternating layer 320 may include any one of a two-dimensional metal, silica (Sio2), and a compound thereof. In particular, the term "two-dimensional metal" refers to a metal provided as a two-dimensional material, and, for example, may be made of copper, gold, or silver. Preferably, the base layer 310 may be made of graphene, and the alternating layer 320 may be made of copper.

However, this is merely illustrative, and it will be apparent to those skilled in the art that the base layer 310 and the alternating layer 320 may be made of various materials, provided that they are composed of a two-dimensional material and/or a nanofilm.

In addition, in the present disclosure, the plurality of base layers 310 may be formed of the same material; however, this is merely illustrative, and the first base nanolayer 311 and the second base nanolayer 312 may be formed of different two-dimensional materials or nanofilms. For example, the first base nanolayer 311 may be made of graphene, and the second base nanolayer 312 may be made of hexagonal boron nitride.

In addition, in the present disclosure, the first to third alternating nanolayers 321, 322, and 323 may also be formed of different two-dimensional materials or nanofilms. For example, the first alternating nanolayer 321 may be made of copper, and the second alternating nanolayer 322 may be made of gold, and the third alternating nanolayer 323 may be made of silver.

Even though the base layer 310 and the alternating layer 320 are formed as multilayers, each component layer of the multilayer may be controlled to have a unit thickness such that the multilayer nanofilm 300, in which the base layer 310 and the alternating layer 320 are stacked, has a stack thickness T at the nanoscale.

That is, a plurality of heterogeneous layers, each formed as a single-layer structure or a multilayer structure, may be stacked and bonded to provide a single multilayer nanofilm 300 having the stack thickness T at the nanoscale. Accordingly, even though upper and lower surfaces of the multilayer nanofilm 300 are in contact with heating bodies, respectively, the heat transfer between the heating bodies and the multilayer nanofilm 300 may be effectively blocked, thereby thermally isolating the heating bodies from each other.

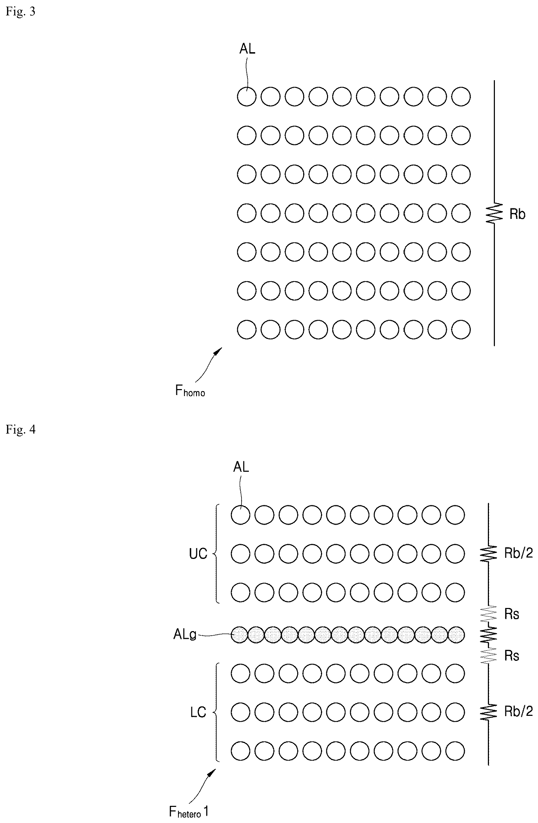

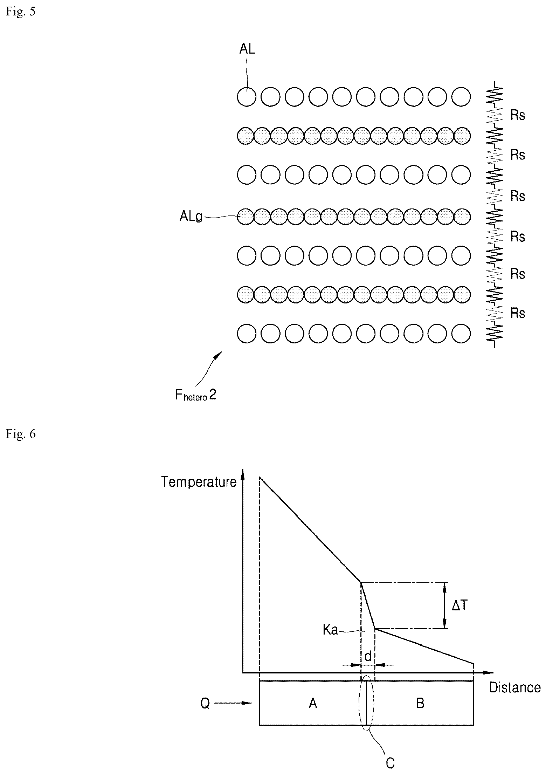

FIGS. 3 to 5 are conceptual views illustrating the increase in interfacial thermal resistance caused by inserting a nanofilm into a bulk film. FIG. 3 is a conceptual view illustrating the structure of a bulk nanofilm made of a single material at the nanoscale, and FIG. 4 is a conceptual view illustrating the structure of a first heterogeneous nanofilm in which a single graphene atomic layer is inserted into the bulk nanofilm shown in FIG. 3. FIG. 5 is a conceptual view illustrating the structure of a second heterogeneous nanofilm in which a plurality of graphene atomic layers are alternately arranged between a plurality of atomic layers of the bulk nanofilm shown in FIG. 3

Referring to FIGS. 3 to 5, a homogeneous film Fhomo composed of a single material may have a crystal structure in which a plurality of atoms are arranged in a three-dimensional structure. The atoms in the same plane may form an atomic layer AL, and the atoms of adjacent atomic layers AL may be coupled to each other by an interlayer coupling force.

When heat is transferred to the homogeneous film Fhomo having the crystal structure as described above, vibration caused by excitations that displace the atoms from their equilibrium position may be generated, and heat transfer through the homogeneous film Fhomo may occur as the vibrations propagate away from the heat source.

Therefore, the bulk heat resistance Rb, which is the thermal resistance of the homogeneous film Fhomo, is the energy per unit length required to excite the solid atoms, which are regularly arranged to form the crystal structure, from their equilibrium positions along the heat transfer path.

When the first heterogeneous film FHETERO1 is formed by inserting a single graphene atomic layer ALg of a two-dimensional material into the bulk homogeneous film Fhomo as described above, the bulk film may be divided by the graphene atomic layer ALg, thereby forming an upper crystal UC composed of a plurality of atomic layers AL and a lower crystal LC composed of a plurality of atomic layers AL.

In this case, although the length along the heat transfer path is reduced to half to reduce the bulk heat resistance Rb to half, the additional thermal resistance introduced by the graphene atomic layer ALg increases significantly, so that the total thermal resistance of the first heterogeneous film Fhetero1 is much greater than the bulk heat resistance Rb of the homogeneous film Fhomo.

The graphene atomic layer ALg composed of a two-dimensional material may have negligible heat transfer along the direction of heat flow and may exhibit a significantly high interfacial thermal resistance Rs at the interfaces with the adjacent upper crystal UC and lower crystal LC.

At the interfaces between the graphene atomic layer ALg and the upper crystal UC and lower crystal LC, the characteristic properties of the two-dimensional material may cause the crystal size to be smaller than the mean free path of phonons, thereby effectively preventing heat transfer.

Accordingly, the heat transferred from the lower crystal LC may be blocked by the graphene atomic layer ALg and be not conducted to the upper crystal UC. That is, the graphene atomic layer ALg may serve as a heat insulating layer between the upper crystal UC and the lower crystal LC.

When a plurality of graphene atomic layers ALg are arranged within the homogeneous film Fhomo, the single homogeneous film Fhomo may be divided into multiple thermal insulation units, thereby further enhancing the thermal insulation properties of the homogeneous film Fhomo.

In particular, as shown in FIG. 5, when the plurality of graphene atomic layers ALg are alternately stacked with the atomic layers of the homogeneous film Fhomo to form the second heterogeneous nanofilm Fhetero2 having a nanostructure, each graphene atomic layer ALg and each atomic layer AL of the homogeneous film may function as a thermal insulation layer that blocks heat transfer.

In this case, the atomic layers AL of the homogeneous film Fhomo may also function as a two-dimensional material, so that the interfacial thermal resistance Rs generated at the interface with the graphene atomic layers ALg may be further enhanced compared to the interfacial thermal resistance Rs shown in FIG. 4. Accordingly, the thermal insulation performance of the second heterogeneous nanofilm Fhetero2 along the heat transfer direction may be further enhanced.

When nanostructures of different heterogeneous solids come into contact with each other, a Kapitza region (Ka in FIG. 6) exists at the grain boundaries of the crystals forming the interface, where a temperature drop occurs.

FIG. 6 is a view illustrating a Kapitza resistance and a Kapitza length generated during a heat transfer between heterogeneous solid planes.

FIG. 6 is a graph showing temperature variation of a hybrid structure in which a first plate A and a second plate B, made of different materials, are in contact, when a constant amount of heat Q is transferred, measured along the distance in the direction of heat transfer.

As shown in FIG. 6, as heat is transferred along the hybrid structure, the temperature gradually decreases along the direction of heat transfer. In this case, in the first plate A and the second plate B, each composed of a homogeneous material, the temperature drop along the distance may be uniform. However, in the boundary region C between the first plate A and the second plate B, a sharp temperature drop ΔT occurs over a short distance.

The sharp temperature drop ΔT in the boundary region may occur because the vibrational characteristics of the lattice structures of the first plate A and the second plate B differ, so that the difference in vibrational characteristics at the boundary region C increases the number of phonons that are reflected or scattered, thereby generating thermal resistance.

The thermal resistance at the boundary region may be determined by the magnitude of the temperature drop ΔT corresponding to the amount of heat Q. Accordingly, when a relatively large temperature drop ΔT occurs over a relatively short distance in the boundary region C, the thermal resistance is high, whereas when a relatively small temperature drop ΔT occurs over a relatively long distance in the boundary region C, the thermal resistance is low.

In particular, when the first plate A and the second plate B are composed of a two-dimensional material or have a nanoscale thickness along the direction of heat transfer, the particle size becomes smaller than the mean free path of phonons, as described above, thereby increasing phonon scattering at the interface.

Accordingly, rather than heat being transferred from the first plate A to the second plate B, heat transfer is predominantly blocked by phonon scattering at the interface, thereby forming the Kapitza resistance that impedes heat transfer from the first plate A to the second plate B.

The Kapitza resistance as described above is determined by the temperature drop ΔT per unit heat Q transferred in the Kapitza region Ka, which is the boundary region where the lattice structure of the solid changes, and the distance corresponding to the Kapitza region Ka to which the Kapitza resistance is applied may be defined as the Kapitza length d. That is, The Kapitza length d represents the distance along the direction of heat transfer in the Kapitza region and may serve as the resistance thickness that suppresses heat transfer.

As shown in FIG. 5, when a plurality of graphene atomic layers ALg are incorporated into the homogeneous film Fhomo to form the second heterogeneous nanofilm Fhetero2, the Kapitza length d associated with each graphene atomic layer ALg increases, thereby enhancing the overall thermal insulation performance of the second heterogeneous nanofilm Fhetero2.

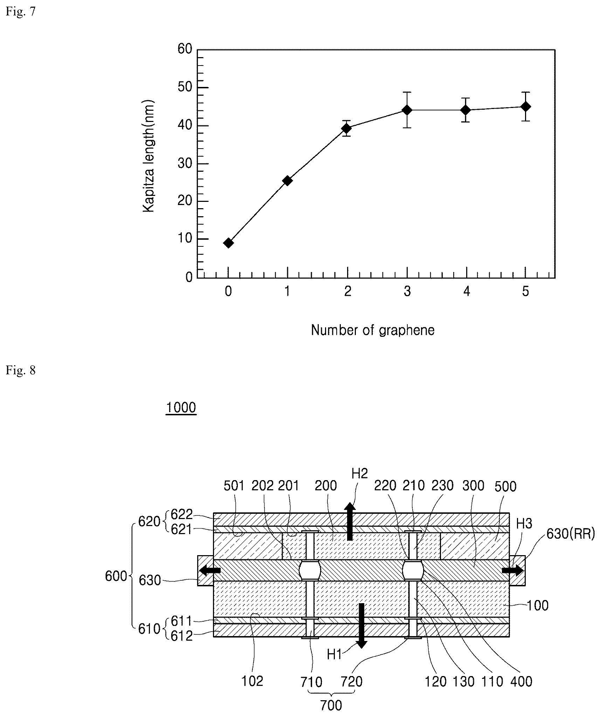

FIG. 7 is a view illustrating the change in Kapitza length according to the number of graphene atomic layers inserted into the homogeneous film shown in FIG. 6.

FIG. 7 is a graph showing the change in Kapitza length d when the multilayer nanofilm shown in FIG. 5 is placed in the Kapitza region Ka of the hybrid structure shown in FIG. 6, while varying the number of graphene atomic layers ALg.

Referring to FIG. 7, compared to the case in which the multilayer nanofilm 300 is arranged with the same type of nanofilm without graphene, when a single graphene layer is added to form a heterogeneous nanofilm, the Kapitza length d in the Kapitza region Ka increases by approximately 15 nm.

In addition, when two graphene layers are added to form a heterogeneous nanofilm, the Kapitza length d in the Kapitza region Ka increases by approximately 13 nm compared to the heterogeneous nanofilm with a single graphene layer.

However, when three graphene layers are added to form a heterogeneous nanofilm, the Kapitza length d in the Kapitza region Ka increases by only approximately 8 nm compared to the heterogeneous nanofilm with two graphene layers, and when four or more layers are added, the Kapitza length d does not substantially increase.

That is, the thermal insulation effect of the heterogeneous nanofilm formed by the addition of graphene is maximized when two graphene layers are added, and when four or more layers are added, the improvement in thermal insulation due to the additional graphene is minimal.

Therefore, when a heterogeneous nanofilm including graphene, as shown in FIG. 5, is used as a heat insulating layer, arranging two to three graphene layers may be the optimal configuration for enhancing the thermal insulation effect.

Accordingly, in one embodiment of the present invention, the multilayer nanofilm 300 is configured such that two base layers 310 composed of graphene are provided. However, it will be apparent to those skilled in the art that, based on the measurement results of FIG. 7 regarding the number of graphene layers and the Kapitza length d, the multilayer nanofilm 300 may alternatively be configured with three base layers 310 and four alternating layers 320.

However, when the base layers 310 are composed of a material other than graphene, the number of base layers 310 having an optimal Kapitza length may be configured differently. Accordingly, it will be apparent to those skilled in the art that the number of base layers 310 and alternating layers 320 in the multilayer nanofilm 300 may be varied depending on the properties and intended use of the base layers 310.

As described above, a plurality of base layers 310 and a plurality of alternating layers 320, each composed of a two-dimensional material or a nanofilm, may be alternately bonded to simultaneously achieve thermal insulation along the stacking direction z and heat dissipation along the horizontal direction.

The base layers 310 and alternating layers 320 may be composed of different materials, so that at the interfaces between the base layers 310 and alternating layers 320, thermal resistance due to crystal sizes smaller than the mean free path of phonons and Kapitza resistance due to differences in crystal types may enhance the thermal insulation properties along the stacking direction. At the same time, the heat dissipation characteristics may be improved by the heat flow along the surface due to the excellent thermal conductivity and Kapitza resistance determined by the properties of the base layers 310 and alternating layers 320.

In other words, within the base layers 310 and alternating layers 320, heat may be transferred along the horizontal direction and dissipate laterally, while heat transferred along the stacking direction z is blocked by the thermal resistance at the interfaces between adjacent base layers 310 and alternating layers 320 composed of heterogeneous materials.

Accordingly, the single multilayer nanofilm 300 may be provided as a heat-dissipating thermal insulation layer that simultaneously performs thermal insulation and heat dissipation.

In this embodiment, the multilayer nanofilm 300 may include three to four copper layers alternately arranged between two to three graphene layers and may have a stack thickness T of approximately 3 nm to 10 nm, preferably 6 nm.

The multilayer nanofilm 300 may include heterogeneous layers with angstrom-scale or nanoscale thicknesses to maximize interfacial thermal resistance, thereby reducing the thickness to approximately one-sixth to one-fifth compared to a bulk film with the same thermal resistance.

For example, the multilayer nanofilm 300 including two graphene layers and three copper layers with the stack thickness T of approximately 6 nm may have substantially the same thermal resistance as a copper film with a thickness of approximately 40 nm.

FIG. 8 is a view illustrating a stacked semiconductor device including the multilayer nanofilm shown in FIG. 1, according to an embodiment of the present disclosure.

Referring to FIG. 8, a stacked semiconductor device 1000 according to an embodiment of the present disclosure may include a base die 100 and a stack die 200 that are electrically connected to each other through a plurality of bonding portions 400 and thermally separated by the multilayer nanofilm 300.

In an embodiment, the base die 100 may include a circuit device having a first integrated circuit. The base die 100 may be configured as a semiconductor device manufactured by a semiconductor device manufacturing process, and the first integrated circuit may include a semiconductor integrated circuit provided in the semiconductor device.

The base die 100 may be provided as a semiconductor package in which a plurality of devices stacked on a semiconductor substrate and separated by insulating layers, together with a plurality of wirings interconnecting the plurality of devices, are sealed from the outside by a packaging process.

Accordingly, a plurality of upper base pads 110 electrically connected to the first integrated circuit may be arranged on an upper base surface 101, which corresponds to the upper surface of the base die 100, and a plurality of lower base pads 120 electrically connected to external devices may be arranged on a lower base surface 102, which corresponds to the lower surface of the base die 100.

For example, the upper base pads 110 may include conductive pads that are arranged on the upper base surface 101 in a matrix pattern, and the lower base pads 120 may include conductive pads that are arranged on the lower base surface 102 in a matrix pattern.

The upper base pads 110 may include either bonding bumps or solder balls for electrically connecting the stack die 200 to the base die 100, and the lower base pads 120 may include either bonding bumps or solder balls for electrically connecting the base die 100 to an external device.

A base penetrating electrode 130 may penetrate the base die 100 and may be connected to the corresponding upper base pad 110 and lower base pad 120.

For example, the base penetrating electrode 130 may be configured as a through-silicon via (TSV) that fills a via hole extending through the silicon substrate of the base die 100 and is bonded to the upper base pads 110 and lower base pads 120 at the top and bottom of the base die 100, respectively.

The base penetrating electrode 130 may include a power line configured to supply power to the base die 100, an address line configured to designate addresses of the first integrated circuit, and a data line configured to read data from or write data to the first integrated circuit.

The external device connected to the base die 100 may include various electronic devices or systems. For example, the lower base pads 120 of the base die 100 may be bonded to a circuit substrate of an external device or to an interposer electrically connected to the external device.

In an embodiment, the stack die 200 may include a circuit device having a second integrated circuit. The stack die 200 may be configured as a semiconductor device manufactured by a semiconductor device manufacturing process, and the second integrated circuit may include a semiconductor integrated circuit provided in the semiconductor device.

The stack die 200 may be provided as a semiconductor package in which a plurality of devices stacked on a semiconductor substrate and separated by insulating layers, together with a plurality of wirings interconnecting the plurality of devices, are sealed from the outside by a packaging process.

Accordingly, a plurality of upper stack pads 210 electrically connected to the second integrated circuit may be arranged on an upper stack surface 201, which corresponds to the upper surface of the stack die 200, and a plurality of lower stack pads 220 electrically connected to an external device or the bonding portion 400 may be arranged on a lower stack surface 202, which corresponds to the lower surface of the stack die 200.

For example, the upper stack pads 210 may include conductive pads that are arranged on the upper stack surface 201 in a matrix pattern, and the lower stack pads 120 may include conductive pads that are arranged on the lower stack surface 202 in a matrix pattern. The upper stack pads 210 and the lower stack pads 220 may include either bonding bumps or solder balls, similar to the upper base pads 110 and the lower base pads 120.

A stack penetrating electrode 230 may penetrate the stack die 200 and may be connected to the corresponding upper stack pad 210 and lower stack pad 220.

Similar to the base penetrating electrode 130, the stack penetrating electrode 230 may be configured as a through-silicon via (TSV) that fills a via hole extending through the silicon substrate of the stack die 200 and is bonded to the upper stack pads 210 and lower stack pads 220 at the top and bottom of the stack die 200, respectively.

The stack penetrating electrode 230 may include a power line configured to supply power to the stack die 200, an address line configured to designate addresses of the second integrated circuit, and a data line configured to read data from or write data to the second integrated circuit.

The present disclosure discloses a single component die is provided as the stack die 200; however, this is merely illustrative, and the stack die 200 may alternatively include a plurality of component dies stacked along the stacking direction z and electrically connected to each other.

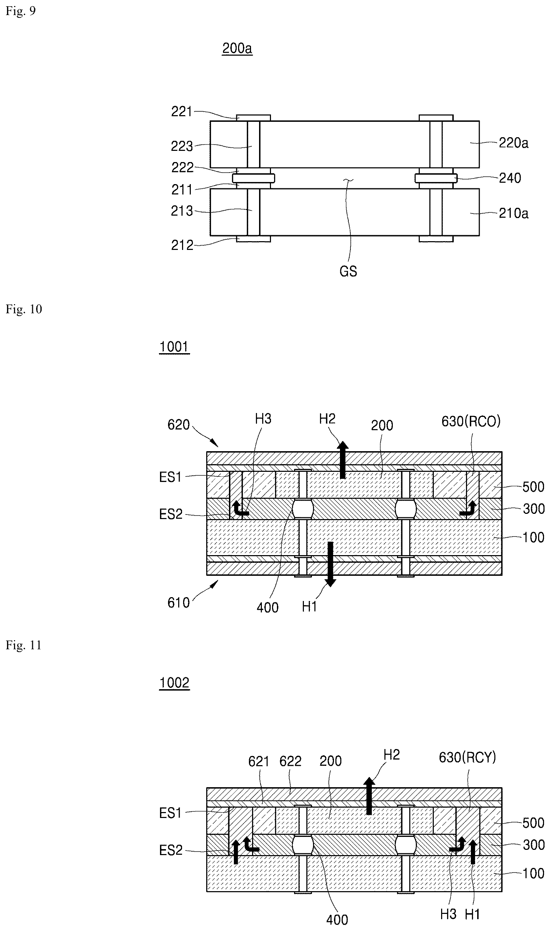

FIG. 9 is a view illustrating a stack die, according to another embodiment of the present disclosure.

Referring to Fig. 9, a modified stack die 200a according to another embodiment of the present disclosure may include a first component die 210a and a second component die 220a stacked on and bonded to the first component die 210a to be electrically connected to the first component die 210a.

For example, the first component die 210a and the second component die 220a may have substantially the same configuration as the stack die 200 shown in FIG. 8. Accordingly, the first component die 210a may include a first upper stack pad 211, a first lower stack pad 212, and a first penetrating electrode 213, and the second component die 220a may include a second upper stack pad 221, a second lower stack pad 222, and a second penetrating electrode 223.

In this case, the first upper stack pad 211 may be coupled to be electrically connected to the second lower stack pad 222, so that the first component die 210a and the second component die 220a may be electrically connected to each other and physically bonded to each other, thereby forming the single modified stack die 200a.

In the present embodiment, a bonding pad 240 may be arranged between the first upper stack pad 211 and the second lower stack pad 222 to physically bond and electrically connect the first upper stack pad 211 and the second lower stack pad 222.

Accordingly, the first penetrating electrode 213 may be electrically connected to the second penetrating electrode 223 through the first upper stack pad 211, the bonding pad 240, and the second lower stack pad 222. With such a structure, N component dies may be stacked to be electrically connected to each other, thereby forming the modified stack die 200a.

The first component die 210a and the second component die 220a may be the same type of semiconductor chip or different types of semiconductor chips depending on the configuration or characteristics of the stacked semiconductor device 1000.

For example, both the first component die 210a and the second component die 220a may be configured as DRAM chips to realize a single memory die, or may be configured as a DRAM chip and a flash memory chip to realize a hybrid memory die.

Referring again to FIG. 8, the lower stack pad 220 of the stack die 200(or the first lower stack pad 212 of the modified stack die 200a shown in FIG. 9) may be configured to be electrically connected to the upper base pad 110 of the base die 100, so that the base die 100 and the stack die 200 may be electrically connected to each other.

For example, the lower stack pad 220 and the upper base pad 110 may be physically bonded and secured to each other by the conductive bonding portion 400 interposed therebetween and may be electrically connected to each other through the bonding portion 400.

In this embodiment, the conductive bonding portion 400 may include a ball grid array (BGA) in which a plurality of base solder balls are arranged in a matrix pattern within the multilayer nanofilm. The ball grid array may be arranged to correspond to the base penetrating electrode 130.

Accordingly, the base die 100 and the stack die 200 may be configured as a single device through the bonding portion 400. A signal applied to the lower base pad 120 may be transmitted to the upper base pad 110 through the base penetrating electrode 130 and then to the stack die 200 through the bonding portion 400.

For example, the base die 100 may include a logic chip or an ASIC chip that performs logic operations and generates relatively high operating heat, whereas the stack die 200 may include a memory chip that performs data storage and generates relatively low operating heat.

In particular, the logic chip performing logic operations may constitute a system processor together with components configured to generate various control commands for controlling the operation of an external device or an external system.

In the present embodiment, the base die 100 may include one of a central processing unit (CPU) configured to drive a computer system, a graphics processing unit (GPU) configured to process graphic data, and an application processor (AP) configured to operate a mobile device.

For example, the base die 100 may be configured as the GPU including a large-capacity logic circuit for processing AI data, and the stack die 200 may be configured as a memory die including a plurality of video memory chips for high-speed data exchange with the GPU and arranged on the base die 100. Accordingly, the stacked semiconductor device 1000 may be configured as a graphic card for processing AI data.

Furthermore, the base die 100 may be configured as the AP including a logic circuit for controlling the operation of a mobile device and processing mobile data, and the stack die 200 may be configured as a memory die including a plurality of mobile memory chips for high-speed data exchange with the AP and arranged on the base die 100. Accordingly, the stacked semiconductor device 1000 may be configured as an operating module for operating a mobile device.

In addition, the base die 100 may be configured as a logic chip capable of handling data transfer, power management, and address commands, and the stack die 200 may be configured as a plurality of homogeneous DRAM chips, thereby forming the stacked semiconductor device 1000 as a high-bandwidth memory (HBM) device.

Furthermore, the base die 100 may be configured as a control chip for driving and controlling a specific external device or external system and for processing data, and the stack die 200 may be configured as memory chips stacked on the control chip through a chip-stacking process, thereby forming the stacked semiconductor device 1000 as a chip stack package.

The chip stack package may be provided as a system-on-chip (SoC) device, which is embedded in a specific external device or external system to perform and control predetermined operations and functions, thereby operating in a system-dependent manner.

For example, the base die 100 may be configured as either an image processing device for processing and controlling image signals or a digital signal processing device for processing and controlling digital signals, and the stack die 200 may include a memory chip capable of storing the processed image signals or digital signals.

The memory chip may be configured as various chips depending on characteristics and use of the stacked semiconductor device 1000. For example, the memory chip may include a volatile memory chip, such as a DRAM chip or a flash chip, and a nonvolatile memory chip such as a read-only memory (ROM).

Since the base die 100 and the stack die 200 are configured as semiconductor devices including integrated circuits, operating heat may be generated during operation. In particular, when the base die 100 is configured as a processor performing logic operations and the stack die 200 is configured as a memory chip for data storage, the stack die 200 may malfunction due to the high operating heat generated by the base die 100.

Thus, the multilayer nanofilm 300 may be interposed between the base die 100 and the stack die 200, to thereby block the heat transfer to the stack die200 from the base die 100.

In an embodiment, the multilayer nanofilm 300 may be stacked along the stacking direction z such that a plurality of base layers 310 and a plurality of alternating layers 320 are alternately stacked, and each of the base layers 310 and the alternating layers 320 has a unit thickness t of angstrom-scale or nanoscale, so that the multilayer nanofilm 300 has a stack thickness T of nanoscale, thereby providing thermal insulation along the stacking direction z and heat dissipation along the horizontal direction perpendicular to the stacking direction z.

The multilayer nanofilm 300 has substantially the same configuration as that of the multilayer nanofilm 300 as shown in FIGS. 1 to 7. Therefore, in FIGS. 8 to 10, the same reference numerals are used for the same components as in FIGS. 1 to 7, and no further detailed description will be provided for such components.

For example, each of the plurality of base layers 310 and the plurality of alternating layers 320 may be configured as one of a single layer and a multilayer. The single layer may include a two-dimensional material having an angstrom-scale thickness or a nanofilm having a nanoscale thickness, and the multilayer may be provided as a stack structure in which at least one of a two-dimensional material, a nanofilm, and a combination thereof is stacked.

In this case, each of the base layers 310 may be composed of a two-dimensional material having a first composition, and each of the alternating layers 320 may be composed of a two-dimensional material having a second composition, so that a single atomic layer having the first composition and another single atomic layer having the second composition may be alternately bonded to each other, thereby forming the multilayer nanofilm 300.

In another embodiment, each of the base layers 310 may be composed of a two-dimensional material having a first composition, and each of the alternating layers 320 may include a plurality of nanofilms having a second composition, so that a single atomic layer having the first composition and a multilayer having the second composition may be alternately bonded to each other, thereby forming the multilayer nanofilm 300.

The plurality of base layers 310 may include graphene, and the plurality of alternating layers 320 may include at least one of a two-dimensional metal material, silica (SiO₂), and a composition thereof. In particular, the two-dimensional metal material may include one of copper, gold, silver, and a compound thereof.

The plurality of base layers 310 may include two to three graphene layers and the plurality of alternating layers 320 may include three to four copper layers, and the stack thickness T may be in a range of about 3 nm to about 10 nm.

First operating heat H1 generated by the base die 100 and second operating heat H2 generated by the stack die 200 may be prevented from being conducted along the stacking direction z by the multilayer nanofilm 300, which serves as a heat insulating layer, thereby blocking heat transfer of the first operating heat H1 to the stack die 200 and heat transfer of the second operating heat H2 to the base die 100. Accordingly, damage to the stack die 200 and the base die 100 caused by the first operating heat H1 and the second operating heat H2 may be effectively prevented by the multilayer nanofilm 300.

However, since the upper base pad 110, the bonding portion 400, and the lower stack pad 220 are enclosed by the multilayer nanofilm 300, signal transmission heat H3 generated during signal transmission along the upper base pad 110, the bonding portion 400, and the lower stack pad 220 may be transferred to the multilayer nanofilm 300 in the horizontal direction from a side surface thereof.

Therefore, the multilayer nanofilm 300 may partially function as a heat dissipating layer that releases the transferred signal transmission heat H3 to the outside. The signal transmission heat H3, having a smaller heat amount than the first operating heat H1 and the second operating heat H2, may be sufficiently dissipated to the outside by the multilayer nanofilm 300.

Accordingly, the multilayer nanofilm 300 may serve as a heat insulating layer to block the transfer of the first operating heat H1 and the second operating heat H2 between the base die 100 and the stack die 200, and simultaneously serve as a heat dissipating layer to dissipate the signal transmission heat H3 outward.

In addition, the multilayer nanofilm 300 may entirely cover the upper base surface 101 and the lower stack surface 202, thereby blocking charge movement as well as heat transfer between the the upper base surface 101 and the lower stack surface 202.

Since the multilayer nanofilm 300 has an angstrom-scale or nanoscale thickness, the lattice size at the interface between the upper base surface 101 and the multilayer nanofilm 300 and at the interface between the stack die 200 and the multilayer nanofilm 300 may become smaller than the mean free path of the charges, which significantly hinders the propagation of charge oscillations.

Accordingly, the charge oscillation between the upper base surface 101 and the lower stack surface 202 may be blocked by the multilayer nanofilm 300, thereby electrically insulating the base die 100 and the stack die 200 from each other.

That is, the multilayer nanofilm 300 may serve as an electrical insulating layer, while also serving as a heat insulating layer and a heat dissipating layer. Thus, the conventional heat insulating layer, heat dissipating layer, and electrical insulating layer arranged on the base die 100 and the stack die 200 may be replaced with a single multilayer nanofilm 300, thereby reducing the overall thickness of the stacked semiconductor device 1000.

The stack die 200 may be secured to the base die 100 by a fixing mold 500.

For example, the fixing mold 500 surrounding the stacking die 200 may be disposed on the upper surface of the multilayer nanofilm 300, which covers the surface of the base die 100 to which the stack die 200 is attached, so that the stack die 200 may be secured to the base die 100. For example, the fixing mold 500 may be configured as an epoxy molding compound (EMC).

In particular, when the stack die 200 is configured as a plurality of component dies as shown in FIG. 9, the fixing mold 500 may integrally include a gap-fill layer filling the gap space GS between the component dies. Accordingly, the stack die 200 may be embedded in the fixing mold 500, except that the upper surface of the stack die 200 at the uppermost portion remains exposed.

The bottom surface of the fixing mold 500 may be in contact with the upper surface of the multilayer nanofilm 300, and the side surface of the fixing mold 500 may be coplanar with the side surface of the base die 100. In addition, the upper surface of the fixing mold 500 may be positioned at the same level as the upper stack surface 201, i.e., the upper surface of the stack die 200 (or when the stack die 200 is configured as a plurality of component dies as shown in FIG. 9, the upper surface of the uppermost component die).

Thus, the upper stack surface 201 may be coplanar with the upper surface of the fixing mold 500 and the stack die 200 may be exposed through the fixing mold 500. That is, the upper stack pad 210 on the upper stack surface 201 may be exposed regardless of the fixing mold 500.

The stacked semiconductor device 1000 may further include a heat sink 600 to release the first operating heat H1 generated from the base die 100 and the second operating heat H2 generated from the stack die 200 to the outside.

For example, the heat sink 600 may include a first sink 610 configured to release the first operating heat H1, a second sink 620 configured to release the second operating heat H2, and a third sink 630 configured to release the signal transmission heat H3.

The first sink 610 may be in contact with the lower base surface 102 and release the first operating heat H1 to the outside.

For example, the first sink 610 may include a first thermal interface material layer 611 entirely covering the lower base surface 102 to absorb the first operating heat H1 and a first heat removal plate 612 entirely covering the surface of the first thermal interface material layer 611 to release the first operating heat H1 outward.

The first thermal interface material layer 611 may be made of a low thermal-resistance material and the fine pores of the lower base surface 102 may be filled with the low thermal-resistance material, thereby extending surface area for heat transfer. For example, the first thermal interface material layer 611 may include a thermal pad shaped into a sheet and composed of a polymer or thermal grease in which metal powder having high thermal conductivity is mixed with a lubricant.

The first heat removal plate 612 may be configured as a thin plate composed of a material having high thermal conductivity, such as copper, aluminum, or a graphite sheet, and may be bonded to the first thermal interface material layer 611.

Accordingly, the first operating heat H1 generated by the base die 100 may be released to the outside through the first thermal interface material layer 611 and the first heat removal plate 612.

In this case, since an external circuit board of an external device or an external system is arranged under the base die 100, the first sink 610 may be positioned between the external circuit board and the base die 100.

Accordingly, the stacked semiconductor device 1000 may further include an external connection terminal 700 having an external connection via 710 that passes through the first sink 610 and is bonded to the lower base pad 120, and an external connecting pad 720 bonded to the external connection via 710, which is positioned on the surface of the first heat removal plate 612, and electrically connected to the external device.

The power signal or the data signal applied from the external device or the external system may be transmitted to the base penetrating electrode 130 via the external connecting pad 720 and the external connecting via 710.

For example, the second sink 620 may include a second thermal interface material layer 621 entirely covering an upper mold surface 501, which is the upper surface of the fixing mold 500, and the upper stack surface 201 to absorb the second operating heat H2, and a second heat removal plate 622 entirely covering the surface of the second thermal interface material layer 621 to release the second operating heat H2 outward.

In particular, the second thermal interface material layer 621 may cover both upper stack surface 201 and the upper mold surface 501, to sufficiently absorb the second operating heat H2 transferred from the stack die 200 via the fixing mold 500, as well as the second operating heat H2 directly transferred from the stack die 200.

The second thermal interface material layer 621 and the second heat removal plate 622 have substantially the same configuration as the first thermal interface material layer 611 and the first heat removal plate 612, so that any further detailed descriptions thereof are omitted.

For example, the third sink 630 may be arranged in contact with the side surface of the multilayer nanofilm 300, so that the signal transmission heat H3, which is generated during signal transmission and transferred laterally in the horizontal direction, may be released outward through the third sink 630.

As shown in FIG. 8, since the fixing mold 500 covers the surface of the multilayer nanofilm 300 and the side surface of the fixing mold 500 is coplanar with the side surfaces of the base die 100 and the multilayer nanofilm 300, the third sink 630 may be configured as a heat releasing ring RR surrounding the multilayer nanofilm 300 along the outer side of the stacked semiconductor device 1000.

For example, the heat releasing ring RR may be configured as a metal ring composed of a metal having high thermal conductivity, similar to the first heat removal plate 612 and the second heat removal plate 622.

Alternatively, the third sink 630 may be configured as a heat removal column RCO such that a side portion of an end portion is surrounded by the multilayer nanofilm 300 and the other end portion is in contact with the second sink 620, to release the signal transmission heat H3 through the second sink 620.

FIG. 10 is a view illustrating a first modified embodiment of the stacked semiconductor device shown in FIG. 8. In FIG. 10, the first modified stacked semiconductor device 1001 has substantially the same configuration as the stacked semiconductor device 1000, except that the heat removal column RCO is provided instead of the heat releasing ring RR. Therefore, in FIG. 10, the same reference numerals are used for the same components as in FIG. 9, and no further detailed description will be provided for such components.

Referring to FIG. 10, the first modified stacked semiconductor device 1001 may include at least one heat removal column RCO as the third sink 630. The heat removal column RCO may penetrate through the fixing mold 500 and the multilayer nanofilm 300 and be configured to transfer the signal transmission heat H3, which is laterally transferred along the multilayer nanofilm 300, to the second sink 620.

After forming the fixing mold 500, the heat removal column RCO may be inserted through the fixing mold 500 and the multilayer nanofilm 300, and then the second thermal interface material layer 621 may be formed to be in contact with a first end surface ES1 of the heat removal column RCO.

In this case, a second end surface ES2 of the heat removal column RCO may be in contact with the upper base surface 101, so that the heat removal column RCO may be surrounded by the multilayer nanofilm 300. Accordingly, the signal transmission heat H3 laterally transferred along the multilayer nanofilm 300 may be released through the second sink 620 via the heat removal column RCO.

The heat removal column RCO may be made of a high thermal conductivity material, such as a metal or graphite, similar to the heat releasing ring RR.

In particular, in the case that the heat removal column RCO has a sufficiently large size and thus the first operating heat H1 generated by the base die 100 is effectively released, the first sink 610 may be omitted.

FIG. 11 is a view illustrating a second modified embodiment of the stacked semiconductor device shown in FIG. 8. In FIG. 11, the second modified stacked semiconductor device 1002 has substantially the same configuration as the first modified stacked semiconductor device 1001, except that both the signal transmission heat H3 and the first operating heat H1 are released through the heat removal column RCO without the first sink 610. Therefore, in FIG. 11, the same reference numerals are used for the same components as in FIG. 10, and no further detailed description will be provided for such components.

Referring to FIG. 11, the second modified stacked semiconductor device 1002 may include a heat releasing cylinder RCY as the third sink 630. The heat releasing cylinder RCY may be formed by sufficiently enlarging the heat removal column RCO and release both the signal transmission heat H3 and the first operating heat H1 through the second sink 620.

For example, the heat releasing cylinder RCY may have the same configuration as the heat removal column RCO, but may be arranged to have a solid cylinder shape with a sufficiently increased width, so that the contact area with the upper base surface 101 may be extended.

Thus, the first end surface ES1 and the second end surface ES2 of the second modified stacked semiconductor device 1002 may be enlarged compared with those of the first modified stacked semiconductor device 1001 shown in FIG. 10, thereby enhancing heat transfer performance. In this case, it will be understood by those skilled in the art that the shape and material of the second sink 620 may also be appropriately modified to improve the heat transfer performance.

In addition, the heat releasing cylinder RCY may be arranged in a greater number than the heat removal column RCO around the peripheral portion of the stack die 200, to release the first operating heat H1 more efficiently.

In particular, although not shown in figures, an auxiliary thermal interface material layer (not shown) may be further provided between the upper base surface 101 and the second end surface ES2, to improve heat transfer efficiency between the base die 100 and the heat releasing cylinder RCY.

Therefore, the first operating heat H1 and the signal transmission heat H3 may be transferred to the second sink 620 through the heat releasing cylinder RCY and released outward. Similar to the heat removal column RCO and the heat releasing ring RR, the heat releasing cylinder RCY may be made of high thermal conductivity material, such as a metal or graphite.

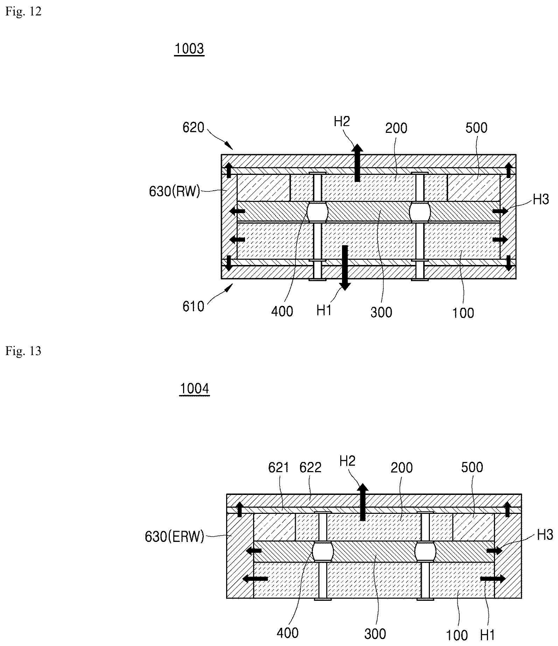

FIG. 12 is a view illustrating a third modified embodiment of the stacked semiconductor device shown in FIG. 8. In FIG. 12, the third modified stacked semiconductor device 1003 has substantially the same configuration as the stacked semiconductor device 1000, except that a heat removal wall RW is provided instead of the heat releasing ring RR for releasing the signal transmission heat H3. Therefore, in FIG. 12, the same reference numerals are used for the same components as in FIG. 8, and no further detailed description will be provided for such components.

Referring to FIG. 12, the third modified stacked semiconductor device 1003 may include a removal wall RW as the third sink 630. The removal wall RW may cover the side surfaces of the fixing mold 500, the multilayer nanofilm 300, and the base die 100, and may transfer the signal transmission heat H3 to the first and second sinks 610 and 620.

Therefore, the removal wall RW may be in contact with the side surfaces of the multilayer nanofilm 300 and the base die 100, and the first end surface ES1 and the second end surface ES2 may be in contact with the first sink 610 and the second sink 620, respectively.

Accordingly, the signal transmission heat H3 laterally transferred along the multilayer nanofilm 300 may be transferred to the removal wall RW and released outward through the first sink 610 and the second sink 620.

In particular, since the removal wall RW is in contact with the side surface of the base die 100, a portion of the first operating heat H1 may also be transferred to the removal wall RW and released outward through the first sink 610 and the second sink 620. Accordingly, the first operating heat H1 may also be efficiently released outward by the removal wall RW.

In particular, similar to the second modified stacked semiconductor device 1002, in the case that the size of the removal wall RW is sufficiently large and thus the first operating heat H1 is sufficiently released outward, the first sink 610 may be omitted.

FIG. 13 is a view illustrating a fourth modified embodiment of the stacked semiconductor device shown in FIG. 8. In FIG. 13, the fourth modified stacked semiconductor device 1004 has substantially the same configuration as the third modified stacked semiconductor device 1003, except that both the signal transmission heat H3 and the first operating heat H1 are released outward through an extended removal wall ERW without the first sink 610. Therefore, in FIG. 13, the same reference numerals are used for the same components as in FIG. 12, and no further detailed description will be provided for such components.

Referring to FIG. 13, the fourth modified stacked semiconductor device 1004 may include an extended removal wall ERW as the third sink 630. The extended removal wall ERW may be configured as an enlarged removal wall RW of which the width is widened, so that both the signal transmission heat H3 and the first operating heat H1 may be released through the extended removal wall ERW and the second sink 620.

For example, the extended removal wall ERW may be formed as a flat plate by extending the removal wall RW in a first direction x and a second direction y, thereby having a length and width greater than those of the removal wall RW. Accordingly, the contact area between the first end surface ES1 and the second thermal interface material layer 621 may be increased.

The first operating heat H1 may be transferred from the base die 100 to the extended removal wall ERW and the signal transmission heat H3 may be transferred from the multilayer nanofilm 300 to the extended removal wall ERW, so that the first operating heat H1 and the signal transmission heat H3 may be released outward through the second sink 620 in contact with the first end surface ES1.

In this case, the extended removal wall ERW may be formed of a material having higher thermal conductivity than the removal wall RW to increase the heat dissipation speed, and the second sink 620 may also have a shape and be made of a material suitable for enhancing the heat transfer performance.

Although not shown in figures, an auxiliary thermal interface material layer (not shown) may be further provided at the interface between the base die 100 and the extended removal wall ERW, thereby enhancing heat transfer efficiency between the base die 100 and the extended removal wall ERW.

Accordingly, the first operating heat H1 and the signal transmission heat H3 may be transferred to the second sink 620 through the extended removal wall ERW and released outward.

According to the multilayer nanofilm 300 and the stacked semiconductor device 1000 including the multilayer nanofilm 300 as described above, a plurality of base layers 310 and a plurality of alternating layers 320, which are composed of a two-dimensional material or a nanofilm, may be alternately bonded to each other, thereby simultaneously achieving thermal insulation along the stacking direction z and heat dissipation along the horizontal direction.

The base layers 310 and the alternating layers 320 may be composed of different materials, so that heat transfer and current flow may be blocked by crystal grains at the interfaces between the base layers 310 and the alternating layers 320, the size of which is smaller than the mean free path of phonons or electrons. In addition, the base layers 310 and the alternating layers 320 may be composed of materials having high thermal conductivity, so that heat flow may be directed along the surfaces of the base layers 310 and the alternating layers 320 due to Kapitza resistance, thereby improving heat dissipation performance.

Accordingly, in the stacked semiconductor device 1000 including the base die 100 and a plurality of stack die 200, a multilayer nanofilm 300 may be interposed between the base die 100 and the stack die 200 to reliably provide thermal insulation therebetween. Furthermore, the signal transmission heat generated during signal transmission between the base die 100 and the stack die 200 may be effectively released along the horizontal direction through the multilayer nanofilm 300.

In addition, the multilayer nanofilm 300 may block the current flow as well as heat flow, thereby electrically insulating the base die 100 and the stack die 200 from each other.

Accordingly, the conventional layers individually arranged between the base die 100 and the stack die 200, such as the insulation layer, the heat dissipating layer, and the heat insulating layer, may be replaced with a single multilayer nanofilm 300 having a nanoscale thickness, which reduces the overall thickness of the stacked semiconductor device 1000 without degrading the thermal insulation performance, heat dissipation performance, or electrical insulation performance.

While the present invention has been described with reference to the exemplary embodiments and drawings above, the invention is not limited to the embodiments and drawings disclosed herein. It will be apparent to those skilled in the art that various modifications may be made without departing from the spirit and scope of the present invention. In addition, even though the effects of the present invention resulting from its specific configurations were not explicitly described in the foregoing embodiments, it is understood that the effects reasonably predictable from such configurations are also to be recognized.

## Claims

1. A multilayer nanofilm comprising:
a plurality of base layers arranged to be spaced apart along a stacking direction; and
a plurality of alternating layers having a composition different from that of the plurality of base layers and interposed between the plurality of base layers such that each of the plurality of alternating layers is alternately disposed with respect to each of the plurality of base layers along the stacking direction and in contact with at least one of the base layers that are adjacent to each other along the stacking direction,
wherein each of the plurality of base layers and the plurality of alternating layers has an angstrom-scale or a nanoscale unit thickness to provide a nanoscale stack thickness, thereby being configured to simultaneously perform thermal insulation along the stacking direction and heat dissipation along a horizontal direction perpendicular to the stacking direction.

2. The multilayer nanofilm according to claim 1, wherein each of the plurality of base layers and the plurality of alternating layers is configured as one of
a single layer that includes one of a two-dimensional material having an angstrom-scale thickness and a nanofilm having a nanoscale thickness, and
a multilayer that includes a stack structure in which at least one of the two-dimensional material, the nanofilm, and a combination thereof is stacked.

3. The multilayer nanofilm according to claim 2, wherein
each of the plurality of base layers is composed of the two-dimensional material having a first composition, and each of the plurality of alternating layers is composed of the two-dimensional material having a second composition, so that a single atomic layer of the first composition and a single atomic layer of the second composition are alternately bonded along the stacking direction.

4. The multilayer nanofilm according to claim 2, wherein
each of the plurality of base layers is composed of the two-dimensional material having a first composition, and each of the plurality of alternating layers is configured as a plurality of nanofilms having a second composition, so that a single atomic layer of the first composition and a multilayer of the second composition are alternately bonded in the stacking direction.

5. The multilayer nanofilm according to claim 1, wherein
heat conducted along a horizontal direction perpendicular to the stacking direction within each of the plurality of base layers and the plurality of alternating layers is configured to dissipate toward through side surfaces thereof, and heat conducted along the stacking direction is configured to be blocked by interfacial thermal resistance provided at the interfaces between the base layer and the alternating layer adjacent to each other.

6. The multilayer nanofilm according to claim 5, wherein
lattice structures of the base layer and the alternating layer at the interface have a size smaller than a mean free path of phonons, and the interfacial thermal resistance includes a Kapitza resistance.

7. A stacked semiconductor device comprising:
a base die including a first integrated circuit;
a stack die including a second integrated circuit and disposed on the base die along a stacking direction perpendicular to the base die such that the second integrated circuit is bonded to the first integrated circuit; and
a multilayer nanofilm positioned between the base die and the stack die, the multilayer nanofilm including a plurality of base layers and a plurality of alternating layers that are alternately stacked and in contact with adjacent base and alternating layers along the stacking direction, each of the plurality of base layers and the plurality of alternating layers having an angstrom-scale or a nanoscale unit thickness, such that the multilayer nanofilm has a nanoscale stack thickness and is configured to simultaneously perform thermal insulation along the stacking direction and heat dissipation along a horizontal direction perpendicular to the stacking direction.

8. The stacked semiconductor device according to claim 7, wherein
each of the plurality of base layers and the plurality of alternating layers is configured as one of
a single layer including one of a two-dimensional material having an angstrom-scale thickness and a nanofilm having a nanoscale thickness, and
a multilayer including a stack structure in which at least one of the two-dimensional material, the nanofilm, and a combination thereof is stacked.

9. The stacked semiconductor device according to claim 8, wherein
each of the plurality of base layers is composed of the two-dimensional material having a first composition, and each of the plurality of alternating layers is composed of the two-dimensional material having a second composition, so that a single atomic layer of the first composition and a single atomic layer of the second composition are alternately bonded along the stacking direction.

10. The stacked semiconductor device according to claim 8, wherein
each of the plurality of base layers is composed of the two-dimensional material having a first composition, and each of the plurality of alternating layers is configured as a plurality of nanofilms having a second composition, so that a single atomic layer of the first composition and a multilayer of the second composition are alternately bonded in the stacking direction.

11. The stacked semiconductor device according to claim 7, wherein the base die includes:
a plurality of upper base pads arranged on an upper base surface, which is an upper surface of the base die, and electrically connected to the first integrated circuit;
a plurality of lower base pads arranged on a lower base surface, which is a lower surface of the base die, corresponding respectively to the upper base pads; and
a plurality of base penetrating electrode penetrating through the base die such that the corresponding upper base pads and lower base pads are connected to each other.

12. The stacked semiconductor device according to claim 11, wherein the stack die includes:
a plurality of upper stack pads arranged on an upper stack surface, which is an upper surface of the stack die, and electrically connected to the second integrated circuit;
a plurality of lower stack pads arranged on a lower stack surface, which is a lower surface of the stack die, corresponding respectively to the upper stack pads; and
a plurality of stack penetrating electrode penetrating through the stack die such that the corresponding upper stack pads and lower stack pads are connected to each other.

13. The stacked semiconductor device according to claim 12, further comprising:
a plurality of bonding portions configured to bond the lower stack pad and the corresponding upper base pad to electrically connect the lower stack pad and the upper base pad, the plurality of bonding portions being enclosed by the multilayer nanofilm;
a fixing mold configured to secure the stack die to the base die with the multilayer nanofilm interposed therebetween and expose a surface of the stack die; and
a heat sink configured to remove operating heat generated by the base die and the stack die to the outside.

14. The stacked semiconductor device according to claim 13, wherein
the multilayer nanofilm is in contact with the upper base surface, the lower stack surface, and a lower surface of the fixing mold, and is provided as
a heat dissipating layer that dissipates heat radiated from the lower stack pad, the upper base pad, and the plurality of bonding portions in the horizontal direction, and as a heat insulating layer that blocks the operating heat generated by the base die and the stack die in the stacking direction to thermally insulate the base die and the stack die.

15. The stacked semiconductor device according to claim 14, wherein
the multilayer nanofilm is provided as an electrical insulating layer that blocks charge oscillations in the stacking direction, thereby electrically insulating the base die from the stack die.

## Amended claims

### Amended claims in accordance with Rule 137(2) EPC.

1. A multilayer nanofilm (300) comprising:
a plurality of base layers (310) arranged to be spaced apart along a stacking direction; and
a plurality of alternating layers (320) having a composition different from that of the plurality of base layers (310) and interposed between the plurality of base layers (310) such that each of the plurality of alternating layers (320) is alternately disposed with respect to each of the plurality of base layers (310) along the stacking direction and in contact with at least one of the base layers (310) that are adjacent to each other along the stacking direction,
wherein the plurality of base layers (310) includes graphene layers and the plurality of alternating layers (320) includes copper layers, such that the multilayer nanofilm (300) has a stack thickness (T) in a range of 3nm to 10nm and the multilayer nanofilm (300) is configured to simultaneously perform thermal insulation along the stacking direction and heat dissipation along a horizontal direction perpendicular to the stacking direction.

2. The multilayer nanofilm (300) according to claim 1, wherein
heat conducted along a horizontal direction perpendicular to the stacking direction within each of the plurality of base layers (310) and the plurality of alternating layers (320) is configured to dissipate toward through side surfaces thereof, and heat conducted along the stacking direction is configured to be blocked by interfacial thermal resistance provided at the interfaces between the base layer and the alternating layer adjacent to each other.

3. The multilayer nanofilm (300) according to claim 2, wherein
lattice structures of the base layer (310) and the alternating layer at the interface have a size smaller than a mean free path of phonons, and the interfacial thermal resistance includes a Kapitza resistance.

4. A stacked semiconductor device comprising:
a base die (100) including a first integrated circuit;
a stack die (200) including a second integrated circuit and disposed on the base die along a stacking direction perpendicular to the base die (100) such that the second integrated circuit is bonded to the first integrated circuit; and
a multilayer nanofilm (300) positioned between the base die (100) and the stack die (200), the multilayer nanofilm (300) including a plurality of base layers (310) and a plurality of alternating layers (320) that are alternately stacked and in contact with adjacent base and alternating layers (320) along the stacking direction, the plurality of base layers (310) including graphene layers and the plurality of alternating layers (320) including copper layers such that the multilayer nanofilm (300) has stack thickness in a range of 3nm to 10nm, the multilayer nanofilm (300) being configured to simultaneously perform thermal insulation along the stacking direction and heat dissipation along a horizontal direction perpendicular to the stacking direction.

5. The stacked semiconductor device according to claim 4, wherein the base die (100) includes:
a plurality of upper base pads (110) arranged on an upper base surface (101), which is an upper surface of the base die (100), and electrically connected to the first integrated circuit;
a plurality of lower base pads (120) arranged on a lower base surface (102), which is a lower surface of the base die (100), corresponding respectively to the upper base pads (110); and
a plurality of base penetrating electrode penetrating through the base die (100) such that the corresponding upper base pads (110) and lower base pads (120) are connected to each other.

6. The stacked semiconductor device according to claim 5, wherein the stack die (200) includes:
a plurality of upper stack pads (210) arranged on an upper stack surface (201), which is an upper surface of the stack die (200), and electrically connected to the second integrated circuit;
a plurality of lower stack pads (220) arranged on a lower stack surface (202), which is a lower surface of the stack die (200), corresponding respectively to the upper stack pads (210); and
a plurality of stack penetrating electrode penetrating through the stack die (200) such that the corresponding upper stack pads (210) and lower stack pads (220) are connected to each other.

7. The stacked semiconductor device according to claim 6, further comprising:
a plurality of bonding portions (400) configured to bond the lower stack pad (210) and the corresponding upper base pad (110) to electrically connect the lower stack pad (210) and the upper base pad (110), the plurality of bonding portions (400) being enclosed by the multilayer nanofilm (300);
a fixing mold (500) configured to secure the stack die (200) to the base die (100) with the multilayer nanofilm (300) interposed therebetween and expose a surface of the stack die (200); and
a heat sink (600) configured to remove operating heat generated by the base die (100) and the stack die (200) to the outside.

8. The stacked semiconductor device according to claim 7, wherein
the multilayer nanofilm (300) is in contact with the upper base surface (101), the lower stack surface (202), and a lower surface of the fixing mold (500), and is provided as
a heat dissipating layer that dissipates heat radiated from the lower stack pad (220), the upper base pad (110), and the plurality of bonding portions (400) in the horizontal direction, and as a heat insulating layer that blocks the operating heat generated by the base die (100) and the stack die (200) in the stacking direction to thermally insulate the base die (100) and the stack die (200).

9. The stacked semiconductor device according to claim 8, wherein
the multilayer nanofilm (300) is provided as an electrical insulating layer that blocks charge oscillations in the stacking direction, thereby electrically insulating the base die (100) from the stack die (200).

10. The multilayer nanofilm (300) according to claim 1, wherein
the plurality of base layers (310) are configured as two to three graphene layers and the plurality of alternating layers (320) are configured as three to four copper layers.

11. The multilayer nanofilm (300) according to claim 10, wherein
the stack thickness (T) is 6nm.

12. The stacked semiconductor device according to claim 4, wherein
the plurality of base layers (310) are configured as two to three graphene layers and the plurality of alternating layers (320) are configured as three to four copper layers.

13. The stacked semiconductor device according to claim 12, wherein
the stack thickness (T) is 6nm.
